# EUROPEAN PATENT APPLICATION

(11) **EP 4 651 635 A1**
(43) Date of publication of application: **19.11.2025**
(21) Application number: 24175659.2
(22) Date of filing: 14.05.2024
(51) Int. Cl.: H05K 1/02, H05K 1/16, H02M 7/00, H05K 1/18

(54) **PCB LAYER STACK-UP AND FLOOR PLANNING**

(71) Applicant: Rimac Technology LLC, 10431 Sveta Nedelja (HR)
(72) Inventor: Kacetl, Tomás, 530 03 Pardubice (CZ); Kacetl, Jan, 530 02 Pardubice (CZ); Sarwar Dilov, Wasim, 10000 Zagreb (HR)
(74) Representative: Grassi, Stefano

(57) **Abstract**

A voltage converting circuit comprises a multi-layer printed-circuit-board stack having an input terminal and a reference terminal, first and second switching elements connected to each other at an output terminal and a parallel-plate capacitor connected with the first and the second switching elements; the stack comprises a top conductive layer provided with said input, reference and output terminals and with a plurality of power-conducting traces, a first and a second metal plane forming said electrodes of the parallel-plate capacitor, a first and a second signal layer having first and second signal-routing traces, wherein the first and the second metal plane are arranged between the top conductive layer and two signal layers, and wherein the top conductive layer and the first metal plane are separated from each other by an insulating layer of the stack only.

## Description

The present invention relates to an electronic circuit arrangement for converting an input voltage to an output voltage and, more particularly, to an electronic circuit arrangement for converting an input voltage to an output voltage realised as a multi-layer printed-circuit-board stack.

Electronic circuit arrangements for converting an input voltage to an output voltage are electrical circuits conventionally known as *power converters* and designed to transform electrical energy supplied by a source into a different form that is - ideally - optimally suited for an output electrical load. For instance, so-called DC-DC power converters are designed to transform an input DC voltage supplied by a DC voltage source and having a predetermined amplitude into an output DC voltage having a different amplitude which can be, for example, higher (*boost converter*) or lower than the input voltage amplitude (*buck converter*), while AC-DC converters (*rectifiers*) transform an AC input waveform into a DC output signal. Conversion may also occur from an AC input signal, for example at a first frequency, to an AC output signal having a different frequency (AC-AC converter), or from a DC input signal to an AC output waveform (DC-AC *inverter*)*.*

Conversion from one form of electrical energy into another is achieved by means of switches which, in modern electrical circuits, are active electronic devices, typically transistors such as power MOSFETs operating in their ON and OFF states, connected via a common path to the input source that supplies the electrical energy to be converted.

An important building block of power converters is represented by capacitors, which are used for intermediate energy storage and for filtering out ripples arising in the input and/or output signals as a result of the switching of the active devices between their ON and OFF states. In particular, a so-called *decoupling capacitor* is generally employed in the input stage of a power converter between the input source and the switches, to provide a low-impedance bypass path between the input source and the earth (also called ground, in American English) for transient currents. The purpose of a decoupling capacitor is to avoid that, if the current drawn by one of the switches changes, this might result in a transient current on the common path connecting the switches to the input source. The ensuing oscillations may damage the switches.

It is apparent that, in view of the purpose of a decoupling capacitor, the electrical path between the switches and the capacitor should ideally be free of any inductance. However, the conductors that are required in any physical circuit to electrically connect the switches with the decoupling capacitor and the input source will inevitably present a finite inductance and thus behave as stray inductive elements, ultimately degrading the performance of the decoupling capacitor and the conversion efficiency of a converter.

Hence, a first technical problem arising in power converters is the need to minimise the overall parasitic inductance associated with the wiring in the electrical path between the decoupling capacitor and the switches in a converter.

A second technical problem arising in power converters is the necessity to shield the signals used to control the switches in a converter from electromagnetic interference with the input and output signals involved in the conversion process.

While the control signals, which typically have the form of voltages applied to the gate and source terminals of transistors employed as switches, have a small amplitude, the input and output signals involved in the conversion process are power signals typically having a large amplitude. Unless appropriate measures are adopted to shield the electrical conductors carrying the signals controlling the operation of the switches, the power signals involved in the conversion process will normally act as an unwanted source of electromagnetic noise on the control signals, thereby disturbing the proper operation of the switches.

The aforementioned problems are exacerbated when the electrical circuit implementing a power converter is realised, as it is nowadays routinely the case, on a printed circuit board. Printed circuit boards, also called PCBs for brevity, consist of a succession of layers of a conductive metal, such as copper, alternating with layers of a rigid dielectric. The succession of alternating conductive and insulating layers is referred to as a *stack-up*; the specific arrangement of traces and components on each layer of the stack-up is referred to as *floor plan.*

The conductive layers in a PCB are typically etched to form conductive traces for connecting components of the electrical circuit, to define mounting pads for mounting discrete components and to open via holes, which are through-holes drilled through the layers of the PCB stack-up, for connecting components mounted on different layers of a printed circuit board.

Conductive traces formed on different layers of a PCB may couple with each other electromagnetically, when electrical currents flow in them, and may as a result form a stray inductive loop through the area arranged between the traces, thereby increasing the overall parasitic inductance associated with the electrical path between the decoupling capacitor and the switches that make up the converter. Furthermore, signals flowing in conductive traces formed in different layers of a PCB may interfere mutually, unless a careful process of selection of the areas where the traces in each layer of the PCB should be arranged, known in the art as *floor planning*, is carried out.

In the prior art, different approaches have been proposed to address the two aforementioned problems.

Document US 2005/0167811 A1, for example, describes a multi-layer electronic module using at least three patterned metal planes arranged in a staggered configuration in a PCB stack-up, to decouple an electronic component mounted on the uppermost surface of the stack-up, on top of the staggered metal planes, from signal wiring formed in the lower layers of the stack-up. The resulting arrangement is structurally complex and does not address the problem of the significant parasitic inductance due to electromagnetic coupling between conductors formed in different layers of the stack-up.

Document JP 2002-9445 A describes a PCB stack-up employing a capacitor formed by two metallised layers and an intervening insulating layer of the stack-up to decouple signal layers formed on the uppermost surface of the PCB from signal layers running on the bottom of the PCB. The arrangement of JP 2002-9445 A reduces electromagnetic interference between signal traces to a certain extent, but it fails to address the problem of reducing the overall stray inductance, because the disclosed stack-up comprises, on both sides of the capacitor, signal traces arranged on adjacent layers and thus susceptible of mutually interfering and coupling to each other inductively.

An object of the present invention is to provide an electronic circuit arrangement for converting an input voltage to an output voltage realised as a multi-layer printed-circuit-board stack and capable of minimising the overall stray capacitance associated with the electrical path between a capacitor which is integrated in the stack and the switching elements which carry out the conversion.

A further object of the present invention is to provide an electronic circuit arrangement for converting an input voltage to an output voltage realised as a multi-layer printed-circuit-board stack and capable of adequately shielding the signals used to control the operation of the switching elements from the high-power signals involved in the conversion process. The present invention also aims at increasing the overall current capability of an electronic circuit arrangement for converting an input voltage to an output voltage realised as a multi-layer printed-circuit-board stack.

In accordance with the present invention, there is provided an electronic circuit arrangement for converting an input voltage to an output voltage, comprising a multi-layer printed-circuit-board stack which, in turn, comprises a plurality of conductive and insulating layers arranged alternately between a first side and a second side of the stack, wherein the stack has an input terminal and a reference terminal for applying the input voltage and an output terminal for outputting the output voltage.

The electronic circuit arrangement according to the present invention furthermore comprises a first switching element and a second switching element arranged in a first region at the first side of the stack and electrically connected to each other at the output terminal, and a parallel-plate capacitor formed by an insulating layer and two conductive layers of the stack arranged on opposite sides of the insulating layer, wherein the two conductive layers form the electrodes of the parallel-plate capacitor and are electrically connected respectively with the first and the second switching element.

In accordance with the present invention, the conductive layers of the stack comprise, arranged in sequence between the first side and the second side of the stack:
- a top conductive layer arranged at the first side of the stack and comprising the aforementioned first region where the first and second switching element are arranged, the top conductive layer being provided with the aforementioned input, reference and output terminals at three respective positions and with a plurality of power-conducting traces configured to carry electrical power signals to be input to, or output by, the first and the second switching element;
- a first metal plane and a second metal plane forming the electrodes of the parallel-plate capacitor, and
- a first signal layer and a second signal layer respectively provided with a plurality of first and second signal-routing traces configured to carry electrical control signals for switching the first and the second switching element.

In the electronic circuit arrangement in accordance with the present invention, the first metal plane and the second metal plane are arranged between the top conductive layer and the two signal layers, thereby electrically shielding the first and the second signal layer from the top conductive layer; furthermore, the top conductive layer and the first metal plane are separated from each other by an insulating layer of the stack only, with no further conductive layer of the stack being arranged between the top conductive layer and the first metal plane.

Advantageously, the parallel-plate capacitor whose electrodes are formed by the two conductive layers of the multi-layer PCB stack in the form of the first and second metal plane is arranged between the top conductive layer and the two signal layers provided with the traces carrying the electrical signals for controlling the switching elements. The parallel-plate capacitor thus separates the top conductive layer from the two signal layers.

This arrangement of the parallel-plate capacitor allows to shield the control signals flowing in the signal layers underneath the capacitor from the power signals flowing in the power-conducting traces of the top conductive layer, as apparent from a consideration of the typical amplitudes exhibited by the control signals and the power signals during operation of the electronic circuit arrangement in accordance with the present invention. The control signals which flow in the signal layers for controlling the switching of the switching elements between their ON and OFF states typically have a much smaller amplitude than the high-power signals which flow in the power-conducting traces of top conductive layer as a result of the conversion of the input voltage into an output voltage: hence, the high-power signals flowing in the top conductive layer would normally interfere with, and disturb, the control signals flowing in the signal layers.

By arranging the parallel-plate capacitor between the top conductive layer and the two signal layers of the multi-layer PCB stack, the metal planes forming the electrodes of the capacitor completely shield the control signals flowing in the signal layers underneath the capacitor from the high-power signals flowing in the top conductive layer.

Advantageously, since no further conductive layer of the stack is arranged between the top conductive layer and the first metal plane that forms the upper electrode of the parallel-plate capacitor, the length of the electrical path between the first region of the top conductive layer where the switching elements are arranged and the parallel-plate capacitor is minimised. As a result, the stray inductance of the electrical path from the first region of the top conductive layer to the parallel-plate capacitor is significantly reduced compared to the prior art.

Preferably, the first metal plane and the second metal plane forming the electrodes of the parallel-plate capacitor are electrically connected respectively with the input terminal and the reference terminal between which the input voltage to be converted is applied, for example by means of an external voltage supply. By connecting the electrodes of the parallel-plate capacitor between the input terminal and the reference terminal, the parallel-plate capacitor acts as a decoupling capacitor between the external voltage supply that provides the input voltage and the switching elements that convert the input voltage into a desired output voltage.

Preferably, the reference terminal is connected to the earth. By connecting the two metal planes that form the electrodes of the parallel-plate capacitor respectively to the input terminal and the reference terminal between which the input voltage to be converted is applied, with the reference terminal being earthed, each of the metal planes is referenced to a constant potential that is either equal to the input voltage (in magnitude) or to the earth potential. The metal planes may thereby advantageously function as a power plane and an earth (or ground) plane for the electronic circuit arrangement according to the present invention.

According to a preferred embodiment of the present invention, the electronic circuit arrangement may advantageously comprise a plurality of via holes configured to electrically connect the top conductive layer with the first metal plane and the second metal plane that form the electrodes of the parallel-plate capacitor.

Preferably, in the preferred embodiment of the present invention the plurality of via holes comprises a first subset of via holes that is disposed in the first region of the top conductive layer where the first and second switching element are arranged, a second subset that is disposed in the top conductive layer at the positions of the input and reference terminals, and a third subset that is disposed outside said first region of the top conductive layer where the first and second switching element are arranged and at positions different from those of the input and reference terminals.

Advantageously, according to a first aspect of the preferred embodiment the first metal plane and the second metal plane that form the electrodes of the parallel-plate capacitor are electrically connected with the first switching element (101) and the second switching element (102) in the first region of the top conductive layer by means of via holes of the first subset, wherein these via holes are formed to extend between the first region of the top conductive layer and a respective area of the first and second metal plane facing said first region. Each area of the first and second metal plane that is connected to the first region of the top conductive layer through via holes of the first subset thus lies opposite the first region.

The connection of the metal planes that form the electrodes of the parallel-plate capacitor with the switching elements in the first region of the top conductive layer by means of via holes extending between the first region and a facing area of each of the metal planes ensures that the length of the electrical path between the switching elements and the parallel-plate capacitor is minimised, thereby further contributing to reducing the overall stray capacitance of the electronic circuit arrangement in accordance with the present invention.

According to a second advantageous aspect of the preferred embodiment of the invention, the first signal-routing traces formed in the first signal layer for carrying control signals (e.g. gate voltages) that are required for controlling the switching of the switching elements (such as transistors) may be aligned with the second signal-routing traces formed in the second signal layer for further carrying the control signals (e.g. source voltages) that are likewise required for controlling the switching of the switching elements. Furthermore, the first signal-routing traces and the second signal-routing traces may respectively have a first width and a second width which are selected such that the first signal-routing traces overlap the second signal-routing traces or vice versa at least partially.

The alignment between the signal-routing traces formed in the two adjacent signal layers minimises the loop area between said traces, thereby reducing the magnetic flux (generated by the currents flowing in the traces) which may be linked with that loop area: as a result, the overall stray inductance of the arrangement is further reduced.

The widths of the thus aligned signal-routing traces formed in the two adjacent signal layers need not be identical: it is sufficient that the first signal-routing traces overlap the second signal-routing traces or vice versa at least partially. The resulting at least partial overlap has the effect of improving noise immunity of the electronic circuit arrangement according to the invention.

The aforementioned first and second aspects of the preferred embodiment may be combined together.

According to the preferred embodiment of the invention, the electronic circuit arrangement may furthermore comprise a plurality of second via holes configured to electrically connect the first signal layer and the second signal layer with the top conductive layer.

By means of said second via holes, the first signal-routing traces in the first signal layer and the second signal-routing traces in the second signal layer may be connected with the first and the second switching element that are arranged in the first region of the top conducting layer.

The connection of the signal-routing traces formed in the signal layer with the switching elements that are arranged in the first region of the top conducting layer by means of dedicated second via holes, distinct from the via holes of the first, second and third subset mentioned above, allows to apply the control signals that are required to turn the switching elements on and off, for example gate-to-source voltages, to the terminals of the switching elements. Routing control signals by means of layers that are separated from the power traces in the top conductive layer improves signal integrity and noise immunity.

According to a third aspect of the of the preferred embodiment of the invention, the first signal layer and the second signal layer may respectively comprise a first and a second metallised pattern having the same shape and being electrically isolated respectively from the first and the second signal-routing traces, wherein the first and the second metallised pattern are respectively formed in the first signal layer and in the second signal layer opposite each other across an insulating layer of the multi-layer PCB stack, to thereby form a further parallel-plate capacitor, in addition to the already described parallel-plate capacitor which, in the rest of the present description, will also be referred to as the *main parallel-plate capacitor.*

The metallised patterns forming the electrodes of this further parallel-plate capacitor may advantageously be connected between the input terminal and the reference terminal (or between any points held at the same potential as the input terminal and any point held at the same potential as the reference terminal) to serve as a further decoupling capacitor. When the metal planes forming the electrodes of the main parallel-plate capacitor are also connected between the input terminal and the reference terminal (or between any point held at the same potential as the input terminal and any point held at the same potential as the reference terminal), the further parallel-plate capacitor advantageously cooperates with the main parallel-plate capacitor to form an equivalent decoupling capacitor having a larger capacitance.

This capacitance may be further increased by mounting one or more additional discrete capacitors on the top conductive layer in a third region adjacent to the first region where the first and the second switching element are arranged, with the electrodes of the one or more additional discrete capacitors being electrically connected to the metal planes forming the electrodes of the parallel-plate capacitor. It is underlined for the sake of clarity that, in order to connect the electrodes of the one or more additional discrete capacitors electrically to the metal planes forming the electrodes of the parallel-plate capacitor, it is sufficient to physically connect the electrodes of the one or more additional discrete capacitors between any two points that are held respectively at the potential of the input terminal and the potential of the reference terminal. Such two points are preferably chosen close to the switching elements, in order to minimise stray inductances. By mounting the one or more additional discrete capacitors in a third region adjacent to the first region where the first and the second switching element are arranged, the length of the electrical path between the switching elements and the one or more additional discrete capacitors is minimised, thereby also minimising the stray inductance associated with that electrical path.

The aforementioned third aspect of the preferred embodiment of the invention may be advantageously combined with the first and/or the second aspect of the preferred embodiment.

The electronic circuit arrangement according to the present invention, including the modifications according to the preferred embodiments and its variants according to the first to third aspect, achieves the object of reducing the overall stray inductance associated with the electrical path that connects the parallel-plate capacitor to the switching elements and the further object of shielding the control signals required to operate the switching elements from the high-power signals flowing in the top conductive layer by means of a specific sequence of *five layers* in a multi-layer PCB, i.e., by means of a specific stack-up, as well as by means of a specific arrangement of the parallel-plate capacitor and of the additional one or more discrete capacitor relative to the first regions where the switching elements are arranged, i.e., by means of a specific floor plan.

In accordance with a further embodiment of the present invention, the electronic circuit arrangement may include a sixth conductive layer in the form of a bottom conductive layer arranged at the second side of the stack.

Advantageously, a dedicated driver circuit configured to generate the electrical control signals required for switching the first and second switching elements may be arranged on the bottom conductive layer. Furthermore, one or more additional discrete capacitors may be arranged on said bottom conductive layer and connected to the metal planes that form the electrodes of the main parallel-plate capacitor, to further increase the overall capacitance of the electronic circuit arrangement and reduce any stray inductances. As already noted above for the additional discrete capacitors on the top conductive layer, also in the case of the additional discrete capacitors arranged on said bottom conductive layer it is sufficient to connect the electrodes of such additional discrete capacitors between any two points that are held respectively at the potential of the input terminal and the potential of the reference terminal.

It is pointed out that the bottom conductive layer is advantageous but not essential for achieving the main objects of the invention, which may be attained solely on the basis of the five-layer PCB stack-up and floor planning described above in the context of the preferred embodiment.

In accordance with the present invention, the first and the second switching elements may each comprise at least one transistor having a gate terminal, a source terminal and a drain terminal. The at least one transistor may preferably be a MOSFET transistor, more preferably a power MOSFET transistor.

Advantageously, each of first and the second switching elements may comprise a plurality of paralleled transistors connected to each other at the respective gate and drain terminals.

By employing a configuration based on a plurality of paralleled transistors for each of the switching elements, the current-handling capability of the electronic circuit arrangement according to the present invention may be significantly increased while retaining the main advantages achieved by the specific PCB stack-up and floor planning of the invention, namely a reduced stray inductance of the electrical path connecting the parallel-plate capacitor with the switching elements and the electromagnetic shielding of the control signals flowing in the signal layers against interference from the high-power signals flowing in the top conductive layer.

To improve the heat dissipation capability of the electronic circuit arrangement according to the present invention, particularly - but not exclusively - when the first and second switching elements each comprise a plurality of paralleled transistors, transistors of the top-side cooled type may advantageously be employed.

The aforementioned configuration based on a plurality of paralleled transistors as well as transistors of the top-side cooled type may be employed both in the preferred embodiment, including its variants according to the first to third aspect, and in the further embodiment involving the inclusion of a bottom conductive layer at the second side of the multi-layer PCB stack.

A plurality of adjacent electronic circuit arrangements in accordance with the present invention may be connected to each other to form a single multi-layer printed circuit board. The resulting arrangement forms an electronic circuit unit exhibiting an increased current-handling capability, while still retaining the main advantages achieved by the specific PCB stack-up and floor planning discussed above in connection with the individual electronic circuit arrangement according to the present invention.

It is underlined that each of the adjacent electronic circuit arrangements connected to form the electronic circuit unit may be realised in accordance with the preferred embodiment of the present invention, including its variants according to the first to third aspect, as well as in accordance with the further embodiment involving the inclusion of a bottom conductive layer at the second side of the multi-layer PCB stack of each of the adjacent electronic circuit arrangements.

In the latter case, where each of the adjacent electronic circuit arrangements comprises a bottom conductive layer, the electronic circuit unit may advantageously comprise one single, common driver circuit arranged on the bottom conductive layer of one of the adjacent electronic circuit arrangements and configured to generate electrical control signals for commonly switching the first and the second switching element of each the adjacent electronic circuit arrangements.

The adoption of one common driver circuit for commonly switching the first and the second switching element of each of the adjacent electronic circuit arrangements, that is to say, for commonly switching all of the switching elements of the electronic circuit unit, allows to achieve an increased current-handling capability in a constructionally simple manner.

Further benefits and advantages of the present invention will become apparent from a reading of the detailed description with appropriate reference to the accompanying drawings. In the following, the terms *stack* and *stack-up* will be used interchangeably.

In the drawings:
figure 1 is a plan view of an electronic circuit unit comprising a plurality of electronic circuit arrangements in accordance with an embodiment of the invention;
figure 2 is a cross-sectional view of the electronic circuit unit of figure 1 in the region of the leftmost electronic circuit arrangement (10);

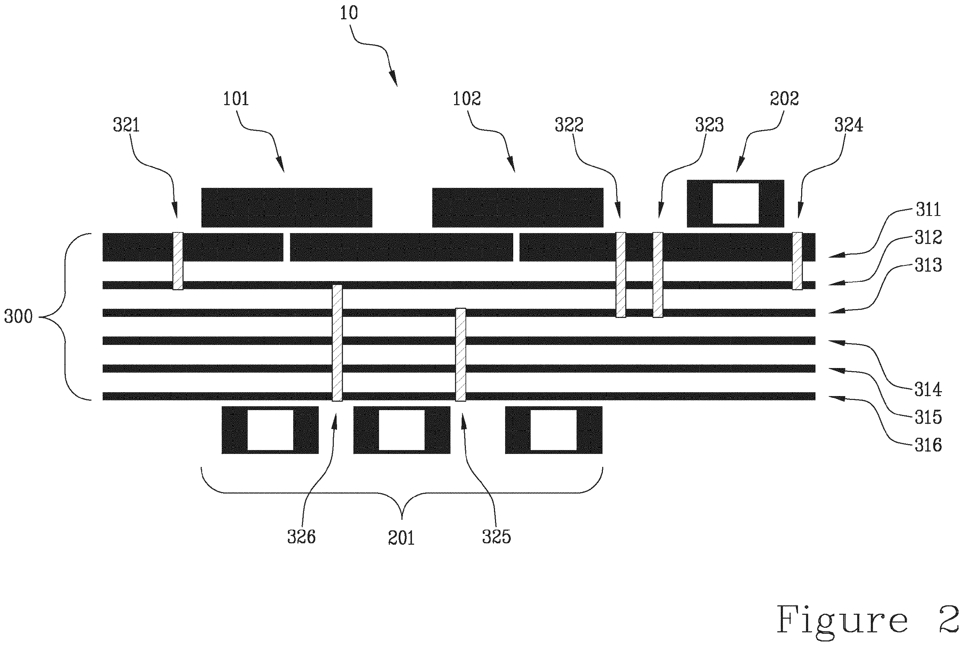

Referring to figure 2 initially, an electronic circuit arrangement (10) for converting an input voltage to an output voltage comprising a multi-layer PCB stack (300) in accordance with an embodiment of the invention comprises a plurality of conductive layers (311, 312, 313, 314, 315, 316) and insulating layers (shown without reference sign) arranged alternately between a first side of the stack (300), coinciding with the top surface of the stack (300), and a second side of the stack (300), coinciding with the bottom surface of the stack (300). Proceeding from the first side of the stack (300), the stack (300) shown in figure 2 comprises a first conductive layer (311) which will be referred to in the following as a top conductive layer, followed by a first insulating layer shown without reference sign, a second conductive layer (312) in the form of a first metal plane, a second insulating layer (without reference sign), a third conductive layer (313) in the form of a second metal plane, a third insulating layer (without reference sign), a fourth conductive layer (314) which will be referred to in the following as a first signal layer, a fourth insulating layer (without reference sign) and a fifth conductive layer (315) which will be referred to in the following as a second signal layer.

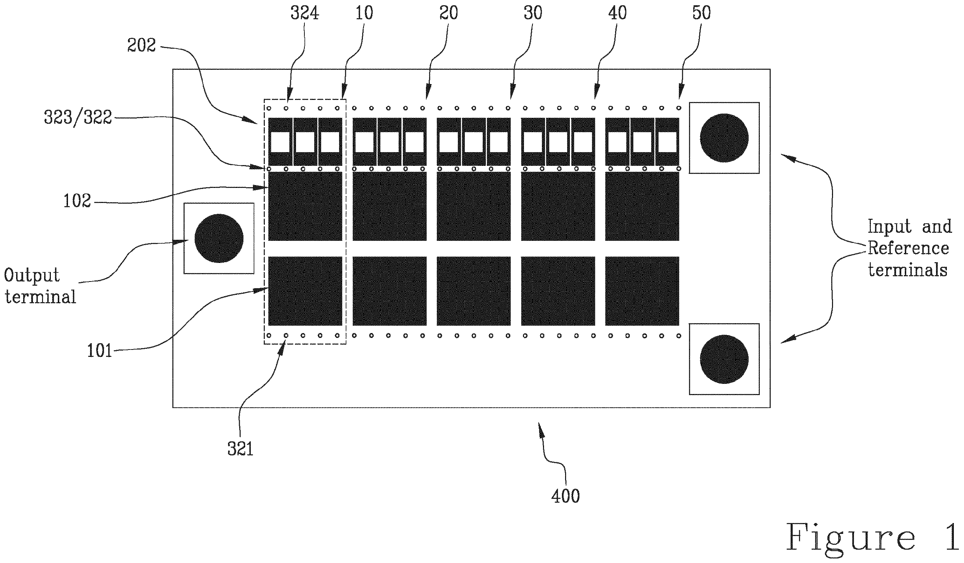

In the embodiment illustrated in figures 1 and 2, the stack (300) also includes a fifth insulating layer arranged beneath the second signal layer (315) and shown without reference number, and a sixth conductive layer (316), arranged at the bottom of the stack-up, i.e., on the second side of the stack (300); in the following, the sixth conductive layer (316) will be referred to as a bottom conductive layer. While the inclusion of a fifth insulating layer and a bottom conductive layer (316) may provide benefits and advantages which will be described below, both layers are not essential for attaining the objectives of the present invention.

The stack (300) according to the present invention also comprises a first switching element (101) and a second switching element (102) arranged in a first region at the first side of said stack (300) and connected to each other electrically at an output terminal described below. As may be seen from figure 2, the first switching element (101) and the second switching element (102) are mounted on the top conductive layer (311) on the upper surface of the stack (300).

The first switching element (101) and the second switching element (102) each comprise at least one active electronic device capable of being switched, through the application of appropriate controls signals, between an ON state and an OFF state. An example of active electronic device that may be employed in each of the first and second switching elements (101, 102) is a three-terminal electronic device such as a transistor, having a gate terminal, a source terminal and a drain terminal. Preferably, the transistor is a MOSFET transistor, more preferably a power MOSFET transistor capable of withstanding high powers. In the case of a transistor being used as an active electronic device in each of the switching elements (101, 102), examples of appropriate control signals for switching the active electronic device between the ON state and the OFF state are gate and source voltages to be applied respectively to the gate and source terminals of the transistor.

Appropriate control signals such as the cited gate and source voltages may be generated by means of an electronic driver, for example a gate driver. To apply the control signals generated by the driver to appropriate terminals of each of the first and second switching elements (101, 102), the first signal layer (314) and the second signal layer (315) of the stack (300) according to the present invention are respectively provided with a plurality of first and second signal-routing traces configured to carry the control signals.

As explained in more detail below, the first and second signal-routing traces are connected to the terminals of each of the first and second switching elements (101, 102) by means of via holes (not shown in the figures), i.e., through-holes drilled through the stack (300) and plated internally with an electrically conductive material to connect the first and second signal-routing traces with appropriate terminals of the first and second switching elements (101, 102) on the top conductive layer (311).

As may be seen from figure 1, each of the first and second switching elements (101, 102) may comprise a plurality of active electronic devices capable of being switched, for example a plurality of transistors: in this case, the plurality of transistors in each of the first and second switching elements (101, 102) are preferably employed in a configuration where the transistors are *paralleled*, i.e., they are arranged next to each other and electrically connected to each other at the respective gate and drain terminals, as shown in figure 2.

The advantage of employing a configuration where each of the first and second switching elements (101, 102) comprises a plurality of paralleled transistors results in an increased current-handling ability of the electronic circuit arrangement. Irrespective of whether each switching element comprises a single transistor or a plurality of paralleled transistors, it may be advantageous to employ transistors of the top-side cooled type to improve the heat dissipation capability of the electronic circuit arrangement, in particular when the electronic circuit arrangement is employed for power electronics applications.

The stack (300) according to the present invention also comprises a pair of terminals, referred to in the following respectively as the input terminal and the reference terminal, for applying the input voltage to be converted, and an output terminal for delivering the output voltage obtained through conversion of the input voltage. In figure 1, the input and reference terminals for applying the input voltage are shown at the right of the top conductive layer, while the output terminal for outputting the output voltage is shown at the left.

The input voltage may be applied by connecting a voltage supply, for example a DC voltage generator, across the input and reference terminals. The reference terminal may be advantageously connected to the earth (or ground) for safety reasons.

As already mentioned, the first switching element (101) and the second switching element (102) are electrically connected to each other at the output terminal of the electronic circuit arrangement in accordance with the present invention. The first switching element (101) and the second switching element (102) may advantageously be connected to each other in accordance with the conventional so-called half-bridge topology; the invention is, however, by no means limited to this topology, which is mentioned here merely as an example of how the first switching element (101) and the second switching element (102) may be electrically connected to each other at the output terminal of the electronic circuit arrangement.

The top conductive layer (311) according to the present invention comprises a plurality of power-conducting traces, not shown in the drawings, configured to carry electrical power signals to be input to, or output by, the first (101) and the second switching element (102). At least one pair of power-conducting traces is connected to the input and reference terminals to receive the input voltage.

As apparent from figure 2, the thickness of the top conductive layer (311) and, as consequence, also the thickness of the power-conducting traces patterned in top conductive layer (311) may advantageously be larger than the thickness of the other conductive layers (312, 313, 314, 315, 316) of the multi-layer PCB stack (300). The higher thickness allows the top conductive layer (311) and the power-conducting traces formed therein to withstand the high powers carried by the power signals involved in the conversion of the input voltage to an output voltage.

Although the top conductive layer (311) is shown in figure 2 as a single layer, it is possible, in accordance with a variant that is not illustrated in the drawings, to realise the top conductive layer (311) as a sequence of conductive sub-layers separated by insulating spacer sub-layers and electrically connected with each other by means of electrically conductive posts or metallised channels, drilled to extend through the insulating spacer sub-layers.

As may be seen from figure 2, in the electronic circuit arrangement in accordance with the invention the two conductive layers (312) and (313) of the stack (300) are in the form of a first and a second metal plane sandwiching an intervening insulating layer, corresponding to the second insulating layer (shown without reference sign) of the stack (300): in other words, the conductive layers (312) and (313) are flat, non-patterned metal surfaces. The first metal plane (312) and the second metal plane (313) may be formed by metallising the opposite major surfaces of the intervening second insulating layer of the stack (300).

The first metal plane (312), the second metal plane (313) and the intervening second insulating layer arranged between the first and second metal plane (312, 313) form a parallel-plate capacitor, wherein the first metal plane (312) and the second metal plane (313) form the electrodes of this parallel-plate capacitor.

As apparent from figure 2, the first metal plane (312) and the second metal plane (313) in the electronic circuit arrangement according to the present invention are arranged between the top conductive layer (311) and the two signal layers (314, 315) described above, thereby electrically shielding the first signal layer (314) and the second signal layer (315) from the top conductive layer (311).

In particular, since the two metal planes (312, 313) forming the electrodes of the parallel-plate capacitor cover the opposite major surfaces of the intervening second insulating layer of the stack (300) almost entirely (bar for any drilled areas necessary for making via holes), any noise signal arising from the flow of power signals in the power-conductive traces of the top conductive layer (311), for example through radiation, cannot reach the first and second signal-routing traces formed in the first and second signal layers (314, 315) because it is blocked by the first and second metal planes (312, 313). The first metal plane (312) and the second metal plane (313) thus suppress or at least reduce electromagnetic interference between the control signals flowing in the signal-routing traces formed in the first and second signal layers (314, 315) and the power signals flowing in the top conductive layer (311).

Advantageously, in the electronic circuit arrangement in accordance with the embodiment of the present invention shown in figures 1 and 2, the first metal plane (312) and the second metal plane (313) are respectively connected to the input terminal and the reference terminal; it is understood that, for the purposes of the invention, it is equally possible to connect the first metal plane (312) to the reference terminal and the second metal plane (313) to the input terminal. Preferably, the connection is made by physically connecting the first and second metal planes to two points that are close to the switching elements (101, 102) and that are held respectively at the input and reference potential. By connecting the first metal plane (312) and the second metal plane (313) to the input and reference terminals or vice versa, the parallel-plate capacitor functions as a decoupling capacitor: it provides a low-impedance bypass path between the input and reference terminals for transient currents to avoid that, if the current drawn by one of the switching elements (101, 102) changes, this might result in a transient current on the common path connecting both switching elements (101, 102) to the voltage source that supplies the input voltage across the input and reference terminals, which transient current could lead to an undesired drop and to oscillations in the voltage seen by the other switching element.

Regardless of whether the first metal plane (312) and the second metal plane (313) forming the electrodes of the parallel-plate capacitor are connected to the input and reference terminals or vice versa, in accordance with the present invention and thus in each of the embodiments described in the present description the top conductive layer (311) and the first metal plane (312) are separated from each other by an insulating layer of the stack (300) only, with no further conductive layer of the stack (300) being arranged between the top conductive layer (311) and the first metal plane (312) that forms the upper electrode of the parallel-plate capacitor.

As a result of this arrangement, since no further conductive layer of the stack is arranged between the top conductive layer and the first metal plane, the length of the electrical path between the top conductive layer where the first and second switching elements (101, 102) are arranged and the parallel-plate capacitor is minimised.

As a result, the stray inductance of the electrical path between the top conductive layer and the parallel-plate capacitor, in particular between the first region where the first and second switching elements (101, 102) are arranged and the parallel-plate capacitor, is significantly reduced in comparison to the arrangements known from the prior art, such as for example JP 2002-9445 A. It is underlined that this beneficial effect is attained regardless of whether a bottom conductive layer (316) is present or not at the second side of the stack (300).

Compared to the prior art, the PCB stack-up comprising the above-described sequence of five conductive layers (311, 312, 313, 314, 315) alternating with four insulating layers thus attains the technical effect of reducing the stray inductance of the electrical path between the top conductive layer (311) and the parallel-plate capacitor whose electrodes are formed by the first and second metal planes (312, 313), as well as the technical effect of shielding the controls signals flowing in the signal layers (314, 315) against electromagnetic interference caused by the high-power signals flowing in the top conductive layer (311), when the electronic circuit arrangement according to the present invention is in use. Both technical effects are achieved independently of the presence of the bottom conductive layer (316) and regardless of whether the parallel-plate capacitor is connected with the input and reference terminals.

It may be seen from the plan view of figure 1 that the electronic circuit arrangement in accordance with the present invention may comprise a plurality of via holes (321, 322, 323, 324) configured to electrically connect the top conductive layer (311) with the first metal plane (312) and the second metal plane (313) located underneath the top conductive layer (311); furthermore, as explained in the following, the electronic circuit arrangement in accordance with the present invention may comprise further via holes, not shown in the drawings, the function of which will be described below.

A first subset of via holes (321, 322) is disposed in the first region of the top conductive layer (311) where the first and second switching elements (101, 102) are arranged, for example at the periphery of that first region, as illustrated in figure 1. It is underlined that the via holes (321, 322) arranged *along the perimeter* of the first region are to be regarded as being *within* the first region, for the purposes of the present invention.

As apparent from the cross-sectional view of figure 2, the first subset of via holes (321, 322) is employed to connect the first metal plane (312) and the second metal plane (313) that form the electrodes of the parallel-plate capacitor with the first region of the top conductive layer (311) and, in particular, with each of the first and second switching elements (101, 102). To this end, the via holes (321, 322) of the first subset are preferably formed in the first region of the top conductive layer (311) beneath appropriate terminals of the switching elements (101, 102) and extend between said first region of the top conductive layer (311) and an area of the first (312) or second metal plane (313) facing said first region: the via holes (321, 322) of the first subset thus extend vertically between the first region of the top conductive layer (311) and the opposite area of the first (312) or second metal plane (313) facing the first region, thereby providing the shortest possible electrical connection between the first and the second switching elements (101, 102) mounted on the top conductive layer (311) and the underlying parallel-plate capacitor. If the via holes (321, 322) of the first subset cannot be arranged exactly beneath the terminals of the switching elements (101, 102), the electrical connection between said via holes (321, 322) of the first subset and the first and second switching elements (101, 102) may be ensured by patterning short traces extending in the first region between each of the via holes (321, 322) of the first subset and the terminals of the switching elements (101, 102).

The illustrated arrangement thus allows to minimise the length of the electrical wiring that connects the first region where the first and second switching elements (101, 102) are arranged with the parallel-plate capacitor, thereby contributing to the reduction of the stray inductance associated with the electrical path between the switching elements (101, 102) and the parallel-plate capacitor. It is underlined that the arrangement relying on the first subset of via holes (321, 322) for connecting the first region where the first and second switching elements (101, 102) are arranged with the parallel-plate capacitor may be employed regardless of whether the bottom conductive layer (316) is present or not in the stack (300).

Advantageously, some of the via holes (321, 322) of the first subset may be exploited to connect the first metal plane (312) and the second metal plane (313) which form the electrodes of the parallel-plate capacitor to the input and reference terminals. To this end, first relay traces (not shown in figure 1) are formed in the top conductive layer (312) to connect the input and reference terminals with a pair of via holes (321, 322) of the first subset located in the first region of the top conductive layer (312): as the via holes of the first subset, as explained above, extend through the stack (300) between the first region of the top conductive layer (311) and an opposite area of the first or second metal plane (312, 313), the aforementioned pair of via holes (321, 322) in combination with the first relay traces establishes an electrical connection between the electrodes of the parallel-plate capacitor and the input and reference terminals of the electronic circuit arrangement according to the present invention.

By connecting the electrodes of the parallel-plate capacitor with the input and reference terminals across which the input voltage is applied, the parallel-plate capacitor in the electronic circuit arrangement in accordance with the present invention functions as a decoupling capacitor.

By employing some of the via holes (321, 322) of the first subset in combination with the above described first relay traces to connect the parallel-plate capacitor with the input and reference terminals, it is possible to realise to connect the parallel-plate capacitor across the input and reference terminals without the need of drilling dedicated via holes for the connection.

The connection relying on the use of some of the via holes (321, 322) of the first subset in combination with first relay traces thus offers the advantage of being simpler from the point of view of the manufacture of the multi-layer PCB stack, since the drilling of dedicated via holes can be avoided.

It is alternatively possible to fabricate a second subset of via holes (not shown in the drawings) in in the top conductive layer (311) at the positions of the input and reference terminals: in this case, dedicated via holes extending between either terminal and an opposite area of the first and second metal planes (312, 313) are drilled through the stack (300). The advantage of this alternative connection is that the electrical path between the electrodes of the parallel-plate capacitor and the input and reference terminals does not require the adoption of relay traces and thus exhibits a negligible stray inductance.

If the value of capacitance of the parallel-plate capacitor described above (also called main parallel-plate capacitor in the present description) is insufficient for an envisaged application of the electronic circuit arrangement in accordance with the present invention, one or more additional discrete capacitors may be employed to increase the overall capacitance of the electronic circuit arrangement.

As illustrated in figure 2, one or more discrete capacitors (202), each having a first and a second electrode, may be mounted on the top conductive layer (311) at the first side of stack (300) in a third region adjacent to the first region at the first side of the stack (300) where the first (101) and the second switching element (102) are arranged. In the plan view of the electronic circuit arrangement shown in figure 1, the third region corresponds to the approximately rectangular area where a row of fifteen discrete capacitors (202), aligned next to each other, are disposed between an upper file of via holes (324) and a lower file of via holes (323). A third subset of the via holes which connect the top conductive layer (311) with the metal planes (312, 313) that form the electrodes of the parallel-plate capacitor may be used to connect the electrodes of the one or more discrete capacitors (202) with the electrodes of the parallel-plate capacitor. The via holes of the third subset are shown in figures 1 and 2 with the reference signs 323 and 324 and are located in the above mentioned third region where the row of twelve discrete capacitors (202) is disposed. The connection of the electrodes of the one or more discrete capacitors (202) with the electrodes of the parallel-plate capacitor by means of the third subset of via holes (323, 324) minimises the length of the electrical path between the one or mode discrete capacitors (202) on the upper conductive layer (311) and the parallel-plate capacitor, thereby contributing to reducing the overall parasitic inductance of the electronic circuit arrangement.

Alternatively, the electrodes of the one or more discrete capacitors (202) may be connected with the electrodes of the parallel-plate capacitor by exploiting some of the via holes (322) of the first subset of via holes which are formed in the first region of the switching elements (101, 102): in this case, the top conductive layer (311) will comprise additional relay traces electrically (not shown in the drawings) connecting the electrodes of the one or more discrete capacitors (202) with selected via holes (322) of the first subset. This configuration has the advantage of being simpler from the point of view of the manufacture of the multi-layer PCB stack, since the drilling of dedicated via holes can be avoided.

When the electronic circuit arrangement comprises a bottom conductive layer (316), as in the embodiment shown in figure 2, it is also possible to mount one or more discrete capacitors (201) on the bottom conductive layer (316) at the second side of the stack (300), to increase the overall capacitance of the electronic circuit arrangement. The one or more discrete capacitors (201) on the bottom conductive layer (316) may be employed on their own or in combination with the one or more discrete capacitors (202) mounted on the top conductive layer (311), depending on the overall value of capacitance required.

The one or more discrete capacitors (201, 202) which may be mounted on the bottom conductive layer (316) and/or the top conductive layer (311) are preferably ceramic capacitors or film capacitors. Ceramic capacitors or film capacitors are known to exhibit a low value of stray inductance in comparison to other conventional discrete capacitors and are thus particularly advantageous for reducing the overall parasitic inductance of the electric path between the parallel-plate capacitor and the switching elements.

Preferably, the one or more discrete capacitors (201) mounted on the bottom conductive layer (316) are arranged in a second region opposite the first region at the first side of the stack (300) where the first and second switching elements (101, 102) are arranged, as shown in figure 2: in other words, the one or more discrete capacitors (201) are mounted in a region of the bottom conductive layer (316) that faces the first region of the top conductive layer (311) where the where the first and second switching elements (101, 102) are disposed.

As illustrated in figure 2, the electrodes of the one or more discrete capacitors (201) which are mounted in the second region of the bottom conductive layer (316) that faces the first region of the top conductive layer (311) may be connected with the first and second metal planes (312, 313) that form the electrodes of the parallel-plate capacitor by means of dedicated via holes, shown in figure 2 with the reference signs 325 and 326. This configuration minimises the length of the electrical path between the one or mode discrete capacitors (201) on the bottom conductive layer (316) and the parallel-plate capacitor, thereby contributing to reducing the overall parasitic inductance of the electronic circuit arrangement.

Alternatively, the electrodes of the one or more discrete capacitors (201) may be connected with the first and second metal planes (312, 313) that form the electrodes of the parallel-plate capacitor by exploiting selected via holes (321, 322) of the first subset of via holes, suitably modified to extend further through the stack (300) from either of the metal planes (312, 313) to the second region of the bottom conductive layer (316) where the one or more discrete capacitors (201) are mounted. This configuration has the advantage of being simpler from the point of view of the manufacture of the multi-layer PCB stack, since the drilling of dedicated via holes can be avoided.

If the value of capacitance of the main parallel-plate capacitor is insufficient for an envisaged application of the electronic circuit arrangement in accordance with the present invention, it is contemplated in accordance with the present invention to form a further parallel-plate capacitor in the first and second signal layers (314, 315) of the stack (300), in addition to the main parallel-plate capacitor whose electrodes are formed by the first and second metal planes (312, 313).

In this case, which is not shown in the figures, the first signal layer (314) and the second signal layer (315) may respectively comprise a first and a second metallised pattern having the same shape and being electrically isolated respectively from the first and the second signal-routing traces, wherein the first and the second metallised pattern are respectively formed in the first signal layer (314) and in the second signal layer (315) opposite each other across an insulating layer of the stack (300), to thereby form the further parallel-plate capacitor.

The first and the second metallised pattern respectively formed in the first signal layer (314) and in the second signal layer (315) of the stack (300) form the electrodes of the further parallel-plate capacitor; the portion of the fourth insulating layer of the stack (300) that is sandwiched between the first metallised pattern in the first signal layer (314) and the second metallised pattern in the second signal layer (315) forms the dielectric region of the further parallel-plate capacitor.

Advantageously, the first and the second metallised pattern forming the electrodes of the further parallel-plate capacitor may be electrically connected respectively with the input terminal and the reference terminal or vice versa, whereby the further parallel-plate capacitor may function as a decoupling capacitor. Similarly to what has already been explained above, the electrical connection of the first and the second metallised pattern with the input terminal and the reference terminal may be achieved by connecting said patterns to any two points held respectively at the potential of the input terminal and at the potential of the reference terminal. When the first metal plane (312) and the second metal plane (313) forming the electrodes of the main parallel-plate capacitor are also electrically connected respectively with the input terminal and the reference terminal (i.e., connected to two points of the arrangements that are held at the potentials of the input and reference terminals) or vice versa, as already described above, the further parallel-plate capacitor and the main parallel-plate capacitor are electrically connected in parallel and form an equivalent decoupling capacitor whose capacitance equals the sum of the capacitances of the individual parallel-plate capacitors. The parallel connection of the main parallel-plate capacitor with the further parallel-plate capacitor may be adopted in any of the embodiments and variants described thus far.

To connect the first and the second metallised pattern forming the electrodes of the further parallel-plate capacitor with the input and reference terminals, via holes of the first subset (321, 322) of via holes, drilled to extend through the stack (300) between the top conductive layer (311) and the first and the second metallised pattern in the in the first signal layer (314) and in the second signal layer (315), may be advantageously employed in combination with the first relay traces described above.

As already explained, first relay traces (not shown in figure 1) may be formed in the top conductive layer (312) to connect the input and reference terminals with a pair of via holes (321, 322) of the first subset located in the first region of the top conductive layer (312) and drilled to extend through the stack (300) down to the first and second signal layers (314, 315). In this manner, an electrical connection is established from the input and reference terminals, through the first relay traces in the top conductive layer (311) and further down the stack (300) by means of the via holes (321, 322) of the first subset, down to the first and second signal layers (314, 315).

Alternatively, the first and the second metallised pattern forming the electrodes of the further parallel-plate capacitor may be electrically connected with the input and reference terminals by means of via holes of the third subset of via holes. In this configuration, which is not illustrated in the drawings, the top conductive layer (311) is patterned to include second relay traces connecting the input terminal and the reference terminal with corresponding via holes of the third subset disposed in the top conductive layer (311) outside the first region where the switching elements (101, 102) are arranged. The corresponding via holes of the third subset are drilled to extend through the stack (300) down to the first and second signal layers (314, 315). In this manner, an electrical connection is established from the input and reference terminals, through the second relay traces in the top conductive layer (311) and further down the stack (300) by means of the via holes (323, 324) of the third subset, down to the first and second signal layers (314, 315).

The connection of the first and the second metallised pattern forming the electrodes of the further parallel-plate capacitor with the input and reference terminals by means of via holes of the first or third subset of via holes in combination with the first or second relay traces in the top conductive layer (311) has the advantage of being simpler from the point of view of the manufacture of the multi-layer PCB stack, since it exploits already present via holes.

If the need to reduce the overall stray inductance of the electronic circuit arrangement prevails over considerations of simplicity of manufacture, it is possible to connect the first and the second metallised pattern forming the electrodes of the further parallel-plate capacitor with the input and reference terminals by means of selected via holes of the second subset, formed to extend through the stack (300) between the input terminal and the reference terminal in the top conductive layer (311) and the first and the second metallised pattern in the first (314) and the second signal layer (315). The via holes of the second subset are located at the positions of the input and reference terminals: hence, no relay traces are needed and a connection between the input and reference terminals and the first and the second metallised pattern in the first (314) and the second signal layer (315) may be established without intermediary relay traces, through said selected via holes of the second subset.

The configurations described above for connecting the input and reference terminals respectively to the electrodes of the main parallel-plate capacitor and to the electrodes of the further parallel-plate capacitors may be adopted, individually or in combination, in an electronic circuit arrangement according to the invention both in the case of a stack (300) *without* the bottom conductive layer (316) *and* in the case of a stack (300) *with* the bottom conductive layer (316).

Although not shown in the drawings, a plurality of second via holes configured to electrically connect the first signal layer (314) and the second signal layer (315) with the top conductive layer (311) is always present in the multi-layer PCB stack (300) of the electronic circuit arrangement in accordance with any of the embodiments of the present invention, in order to ensure that the first signal-routing traces in the first signal layer (314) and the second signal-routing traces in the second signal layer (315) are connected with the first (101) and the second switching element (102), whereby appropriate electrical control signals flowing in the first and second signal-routing traces may be routed to appropriate terminals of the first and second switching elements (101, 102), to control their switching between the ON state and the OFF state.

The electronic circuit arrangement in accordance with the present invention may advantageously be provided with a plurality of interface terminals for electrically connecting the electronic circuit arrangement to at least one external device. Preferably, the interface terminals are assembled on the top conductive layer (311) at the positions of via holes of the second subset of via holes and each interface terminal is provided with contact pins, wherein the contact pins of each interface terminal are advantageously housed in a respective via hole of the second subset of via holes, to thereby electrically connect each interface terminal with a respective via hole.

To generate the aforementioned electrical control signals necessary for switching the first and second switching elements (101, 102), a dedicated driver circuit, not shown in the drawings, may be advantageously arranged on the bottom conductive layer (316). The dedicated driver circuit may be electrically connected to the first and second signal-routing traces respectively formed in the first and second signal layers (314, 315), to provide the control signals to the first and second switching elements (101, 102) via the first and second signal-routing traces. As explained beforehand, the thus generated control signals are routed from the first and second signal-routing traces to the first and second switching elements (101, 102) mounted on the top conductive layer (311) by means of the plurality of second via holes.

The dedicated driver circuit arranged on the bottom conductive layer (316) may be employed in combination with one or more of the discrete capacitors (201, 202) which, as already described above, may be arranged on the top conductive layer (311) and/or the bottom conductive layer (316) to increase the overall capacitance of the electronic circuit arrangement in accordance with the present invention. The dedicated driver circuit arranged on the bottom conductive layer (316) may also be employed in combination with the further parallel-plate capacitor described above, possibly in combination with the discrete capacitors (201, 202).

As illustrated in figure 1, a plurality of electronic circuit arrangements (10, 20, 30, 40, 50) as described above, each including the bottom conductive layer (316), may be combined to obtain an electronic circuit unit (400) exhibiting an increased current-handling capability.

The electronic circuit unit (400) comprises a plurality of adjacent electronic circuit arrangements (10, 20, 30, 40, 50) as described above, wherein the multi-layer printed-circuit-board stacks (300) of the adjacent electronic circuit arrangements (10, 20, 30, 40, 50) are connected to each other mechanically and electrically to form a single multi-layer printed circuit board.

Advantageously, a common driver circuit may be arranged on the bottom conductive layer (316) of one of the adjacent electronic circuit arrangements (10, 20, 30, 40, 50), wherein the common driver circuit may be configured to generate electrical control signals for commonly switching the first (101) and the second switching element (102) of each of the adjacent electronic circuit arrangements (10, 20, 30, 40, 50) that form the electronic circuit unit (400).

The advantage of employing a common driver circuit for generating the electrical control signals required for switching the first and second switching elements of each of the adjacent electronic circuit arrangements (10, 20, 30, 40, 50) is that a single driver circuit may be used to commonly control all the switching elements of the electronic circuit unit (400), with a significant reduction of costs and space occupation as well as a simplification of the driving circuitry, compared to the case where multiple drivers are used and it becomes necessary to ensure a matched timing of operation of such multiple drivers.

When a common driver circuit arranged on the bottom conductive layer (316) of one of the adjacent electronic circuit arrangements (10, 20, 30, 40, 50) is employed for commonly switching the first (101) and the second switching element (102) of each of the adjacent electronic circuit arrangements (10, 20, 30, 40, 50), the input terminals of adjacent electronic circuit arrangements are preferably connected to each other electrically so as to be equipotential; furthermore, also the reference terminals of adjacent electronic circuit arrangements are preferably connected to each other electrically so as to be equipotential.

Advantageously, the input terminal and the reference terminal of a single one of the adjacent electronic circuit arrangements that form the electronic circuit unit may be configured to receive the input voltage, thereby functioning as common input and reference terminals for the electronic circuit unit. In this case, as shown in figure 1, there will be a single pair of terminals (shown on the right side in figure 1) for applying a common input voltage to the adjacent electronic circuit arrangements (10, 20, 30, 40, 50) that form the electronic circuit unit (400).

The electronic circuit unit according to this further embodiment, provided with a common driver circuit as described, may advantageously be employed in combination with a voltage supply configured to apply the input voltage across said common input and reference terminals, to realise a power converter having an enhanced current-handling capability and reduced overall stray inductance and capable of shielding the control signals used for switching the switching elements of the power converter from the power signals involved in the conversion process.

Although the invention has been explained above in relation to its embodiments, it is understood that modifications and variations may be made without departing from the scope of the present invention as defined in the appended claims.

## Claims

1. Electronic circuit arrangement (10, 20, 30, 40, 50) for converting an input voltage to an output voltage, comprising:
- a multi-layer printed-circuit-board stack (300) comprising a plurality of conductive (311, 312, 313, 314, 315, 316) and insulating layers arranged alternately between a first side and a second side of the stack (300), said stack (300) having an input terminal and a reference terminal for applying the input voltage and an output terminal for outputting the output voltage, preferably the reference terminal being connected to the earth;
- a first switching element (101) and a second switching element (102) arranged in a first region at the first side of said stack (300) and electrically connected to each other at the output terminal;
- a parallel-plate capacitor formed by an insulating layer and two conductive layers (312, 313) of said stack (300) arranged on opposite sides of said insulating layer, said two conductive layers (312, 313) forming the electrodes of the parallel-plate capacitor and being electrically connected respectively with the first (101) and the second switching element (102),
wherein the conductive layers (311, 312, 313, 314, 315, 316) of the stack (300) comprise, arranged in sequence between the first side and the second side:
- a top conductive layer (311) arranged at the first side of the stack (300) and comprising said first region where the first (101) and second switching element (102) are arranged, the top conductive layer (311) being provided with said input, reference and output terminals at three respective positions and with a plurality of power-conducting traces configured to carry electrical power signals to be input to, or output by, the first (101) and the second switching element (102),
- a first metal plane (312) and a second metal plane (313) forming said electrodes of the parallel-plate capacitor,
- a first signal layer (314) and a second signal layer (315) respectively provided with a plurality of first and second signal-routing traces configured to carry electrical control signals for switching the first (101) and the second switching element (102),
**characterised in that**
the first metal plane (312) and the second metal plane (313) are arranged between the top conductive layer (311) and said two signal layers (314, 315), thereby electrically shielding the first (314) and the second signal layer (315) from the top conductive layer (311),
and
the top conductive layer (311) and the first metal plane (312) are separated from each other by an insulating layer of the stack (300) only, no further conductive layer of the stack (300) being arranged between the top conductive layer (311) and the first metal plane (312).

2. Electronic circuit arrangement (10, 20, 30, 40, 50) according to claim 1, further comprising a plurality of via holes (321, 322, 323, 324) configured to electrically connect the top conductive layer (311) with the first metal plane (312) and the second metal plane (313), wherein:
- a first subset (321, 322) of the plurality of via holes (321, 322, 323, 324) is disposed in the first region of the top conductive layer (311) where the first (101) and second switching element (102) are arranged;
- a second subset of the plurality of via holes (321, 322, 323, 324) is disposed in the top conductive layer (311) at the positions of the input and reference terminals; and
- a third subset (323, 324) of the plurality of via holes (321, 322, 323, 324) is disposed outside said first region of the top conductive layer (311) where the first (101) and second switching element (102) are arranged and at positions different from those of the input and reference terminals.

3. Electronic circuit arrangement (10, 20, 30, 40, 50) according to claim 2, wherein the first metal plane (312) and the second metal plane (313) are electrically connected with the first switching element (101) and the second switching element (102) in first region of the top conductive layer (311) by means of via holes of said first subset (321, 322), said via holes being formed to extend between said first region of the top conductive layer (311) and a respective area of the first (312) and second metal plane (313) facing said first region.

4. Electronic circuit arrangement (10, 20, 30, 40, 50) according to claim 3, further comprising a plurality of interface terminals for electrically connecting the electronic circuit arrangement to at least one external device, wherein each interface terminal is provided with contact pins and the interface terminals are assembled on the top conductive layer (311) at the positions of via holes of said second subset, the contact pins of each interface terminal being housed in a respective via hole of said second subset to thereby electrically connect each interface terminal with the respective via hole.

5. Electronic circuit arrangement (10, 20, 30, 40, 50) according to any of claims 2 to 4, wherein the first signal-routing traces in the first signal layer (314) are aligned with the second signal-routing traces in the second signal layer (315), and wherein the first signal-routing traces and the second signal-routing traces respectively have a first width and a second width which are selected such that the first signal-routing traces overlap the second signal-routing traces or vice versa at least partially.

6. Electronic circuit arrangement (10, 20, 30, 40, 50) according to claim 5, further comprising a plurality of second via holes configured to electrically connect the first signal layer (314) and the second signal layer (315) with the top conductive layer (311), wherein the first signal-routing traces in the first signal layer (314) and the second signal-routing traces in the second signal layer (315) are connected with the first (101) and the second switching element (102) that are arranged in the first region of the top conducting layer (311) by means of said second via holes.

7. Electronic circuit arrangement (10, 20, 30, 40, 50) according to any of claims 2 to 6, wherein the first signal layer (314) and the second signal layer (315) respectively comprise a first and a second metallised pattern having the same shape and being electrically isolated respectively from the first and the second signal-routing traces, wherein the first and the second metallised pattern are respectively formed in the first signal layer (314) and in the second signal layer (315) opposite each other across an insulating layer of the stack (300), to thereby form a further parallel-plate capacitor.

8. Electronic circuit arrangement (10, 20, 30, 40, 50) according to claim 7, wherein the top conductive layer (311) comprises first relay traces configured to electrically connect the input terminal and the reference terminal with via holes of said first subset (321, 322), wherein the first metal plane (312) and the second metal plane (313) forming the electrodes of the parallel-plate capacitor are electrically connected respectively with the input terminal and the reference terminal or vice versa by means of said first relay traces and the via holes of said first subset (321, 322).

9. Electronic circuit arrangement (10, 20, 30, 40, 50) according to claim 8, wherein the first and the second metallised pattern forming the electrodes of the further parallel-plate capacitor are electrically connected respectively with the input terminal and the reference terminal or vice versa by means of said first relay traces and via holes of said first subset (321, 322) formed to extend through the stack (300) between the input terminal and the reference terminal in the top conductive layer (311) and the first and the second metallised pattern in the first (314) and the second signal layer (315).

10. Electronic circuit arrangement (10, 20, 30, 40, 50) according to claim 7, wherein the top conductive layer (311) comprises second relay traces configured to electrically connect the input terminal and the reference terminal with corresponding via holes of the third subset (323, 324) of the plurality of via holes (321, 322, 323, 324), and wherein the first and the second metallised pattern forming the electrodes of the further parallel-plate capacitor are electrically connected respectively with the input terminal and the reference terminal or vice versa by means of said second relay traces and said corresponding via holes of said third subset (323, 324), said corresponding via holes being formed to extend between the input terminal and the reference terminal in the top conductive layer (311) and the first and the second metallised pattern in the first (314) and the second signal layer (315).

11. Electronic circuit arrangement (10, 20, 30, 40, 50) according to any of claims 7, 9 or 10, wherein the first metal plane (312) and the second metal plane (313) forming the electrodes of the parallel-plate capacitor are electrically connected respectively with the input terminal and the reference terminal or vice versa by means of via holes of said second subset.

12. Electronic circuit arrangement (10, 20, 30, 40, 50) according to claim 7 or claim 8, wherein the first and the second metallised pattern forming the electrodes of the further parallel-plate capacitor are electrically connected respectively with the input terminal and the reference terminal or vice versa by means of selected via holes of the second subset of the plurality of via holes (321, 322, 323, 324), said selected via holes being formed to extend through the stack (300) between the input and reference terminals in the top conductive layer (311) and the first and second metallised pattern in the first (314) and the second signal layer (315).

13. Electronic circuit arrangement (10, 20, 30, 40, 50) according to any of claims 2 to 12, wherein the multi-layer printed-circuit-board stack (300) further comprises a bottom conductive layer (316) arranged at the second side of the stack (300).

14. Electronic circuit arrangement (10, 20, 30, 40, 50) according to claim 13, further comprising at least one first discrete capacitor (201) having a first and a second capacitor electrode and mounted on the bottom conductive layer (316) at the second side of the stack (300) in a second region opposite the first region at the first side of the stack (300) where the first (101) and the second switching element (102) are arranged, wherein the at least one first discrete capacitor (201) is preferably a ceramic capacitor or a film capacitor.

15. Electronic circuit arrangement (10, 20, 30, 40, 50) according to claim 14, wherein the first and the second capacitor electrode of the at least one first discrete capacitor (201) are respectively connected to either of the metal planes (312, 313) of the stack (300) by means of selected via holes of the first subset (321, 322) of the plurality of via holes (321, 322, 323, 324), said selected via holes being formed to extend further through the stack (300) from either of said metal planes (312, 313) to said second region in the bottom conductive layer (316).

16. Electronic circuit arrangement (10, 20, 30, 40, 50) according to claim 14, further comprising a plurality of dedicated via holes (325, 326) configured to electrically connect the bottom conductive layer (316) with the first metal plane (312) and the second metal plane (313) of the stack (300) only, wherein the first and the second capacitor electrode of the at least one first discrete capacitor (201) are respectively connected to either of the metal planes (312, 313) of the stack (300) by means of said dedicated via holes (325, 326).

17. Electronic circuit arrangement (10, 20, 30, 40, 50) according to any of claims 2 to 16, further comprising at least one second discrete capacitor (202) having a first and a second capacitor electrode and mounted on the top conductive layer (311) at the first side of stack (300) in a third region adjacent to the first region at the first side of the stack (300) where the first (101) and the second switching element (102) are arranged, wherein the at least one second discrete capacitor (201) is preferably a ceramic capacitor or a film capacitor.

18. Electronic circuit arrangement (10, 20, 30, 40, 50) according to claim 17, wherein the third subset (323, 324) of the plurality of via holes (321, 322, 323, 324) is disposed in said third region adjacent to the first region at the first side of the stack (300), and wherein the first and the second capacitor electrode of the at least one second discrete capacitor (202) are respectively connected to either of the metal planes (312, 313) of the stack (300) by means of via holes of said third subset formed to extend through the stack (300) between said the top conductive layer (311) in said third region and either of said metal planes (312, 313).

19. Electronic circuit arrangement (10, 20, 30, 40, 50) according to claim 17, wherein the top conductive layer (311) comprises third relay traces configured to electrically connect said third region with selected vias of the first subset (321, 322) of the plurality of via holes (321, 322, 323, 324), the first and the second capacitor electrode of at least one second discrete capacitor (202) being respectively connected to either of the metal planes (312, 313) of the stack (300) by means of said third relay traces and said selected vias of the first subset (321, 322).

20. Electronic circuit arrangement (10, 20, 30, 40, 50) according to any of claims 2 to 19, wherein each of the first (101) and second switching elements (102) comprises at least one transistor having a gate terminal, a source terminal and a drain terminal, wherein preferably each transistor is of the top-side cooled type.

21. Electronic circuit arrangement (10, 20, 30, 40, 50) according to claim 20, wherein each of the first (101) and second switching elements (102) comprises a plurality of paralleled transistors connected to each other at the respective gate, source and drain terminals.

22. Electronic circuit arrangement (10, 20, 30, 40, 50) according to claim 20 or 21, wherein the first and the second signal-routing traces in the first signal layer (314) and in the second signal layer (315) are respectively connected with the gate terminal and the source terminal of each of the first (101) and second switching element (102) or vice versa.

23. Electronic circuit arrangement (10, 20, 30, 40, 50) according to any of claims 1 to 22, wherein the top conductive layer (311) consists of a sequence of conductive sub-layers separated by insulating spacer sub-layers and electrically connected with each other by means of electrically conductive posts or metallised channels drilled to extend through said insulating spacer sub-layers.

24. Electronic circuit arrangement (10, 20, 30, 40, 50) according to any of claims 13 to 23, further comprising a dedicated driver circuit arranged on the bottom conductive layer (316) and configured to generate said electrical control signals for switching the first (101) and the second switching element (102), wherein the dedicated driver circuit is electrically connected to the first and the second signal-routing traces respectively formed in the first (314) and in the second signal layer (315).

25. Electronic circuit unit (400) comprising a plurality of adjacent electronic circuit arrangements (10, 20, 30, 40, 50) according to any of claims 1 to 12, wherein the multi-layer printed-circuit-board stacks (300) of said adjacent electronic circuit arrangements are connected to each other to form a single multi-layer printed circuit board.

26. Electronic circuit unit (400) comprising a plurality of adjacent electronic circuit arrangements (10, 20, 30, 40, 50) according to any of claims 13 to 23, wherein the multi-layer printed-circuit-board stacks (300) of said adjacent electronic circuit arrangements are connected to each other to form a single multi-layer printed circuit board, the electronic circuit unit further comprising a common driver circuit arranged on the bottom conductive layer (316) of one of the adjacent electronic circuit arrangements and configured to generate said electrical control signals for commonly switching the first (101) and the second switching element (102) of each electronic circuit arrangement.

27. Electronic circuit unit (400) according to claim 26, wherein:
- the input terminals of adjacent electronic circuit arrangements (10, 20, 30, 40, 50) are electrically connected to each other so as to be equipotential;
- the reference terminals of adjacent electronic circuit arrangements (10, 20, 30, 40, 50) are electrically connected to each other so as to be equipotential;
- the input terminal and the reference terminal of a single one of said adjacent electronic circuit arrangements are configured to receive the input voltage.
Power converter comprising an electronic circuit unit (400) according to claim 27 and a voltage supply for applying the input voltage to the input terminal and the reference terminal of said single one of the adjacent electronic circuit arrangements (10, 20, 30, 40, 50).
